# EUROPEAN PATENT APPLICATION

(11) **EP 2 047 980 A1**
(43) Date of publication of application: **15.04.2009**
(21) Application number: 07791792.0
(22) Date of filing: 26.07.2007
(51) Int. Cl.: B32B 9/00, B65D 23/02, B65D 25/14, C23C 16/42

(54) **PLASTIC MOLDED ARTICLE COMPRISING VAPOR DEPOSITION FILM FORMED BY PLASMA CVD METHOD**

(30) Priority: 28.07.2006 JP 2006205915
(71) Applicant: Toyo Seikan Kaisha, Ltd., Tokyo 100-8522 (JP)
(72) Inventor: YAMADA, Kouji, Yokohama-shi Kanagawa 240-0062 (JP); IEKI, Toshihide, Yokohama-shi Kanagawa 240-0062 (JP); AIHARA, Takeshi, Yokohama-shi Kanagawa 240-0062 (JP)
(74) Representative: Manley, Nicholas Michael
(86) International application number: PCT/JP2007/065112
(87) International publication number: WO 2008/013314

(57) **Abstract**

This invention relates to a plastic formed article having a vapor-deposited film on a surface of a plastic substrate by a plasma CVD method, the vapor-deposited film including an organosilicon vapor-deposited layer on the surface of the plastic substrate 1 and containing no oxygen, and a silicon oxide vapor-deposited layer on the organosilicon vapor-deposited layer. The plastic formed article not only features favorable gas-barrier property but also effectively prevents the generation of offensive odor at the time of vapor deposition and, further, offers excellent flavor-retaining property.

## Description

### <Technical Field>

This invention relates to a plastic formed article such as a plastic bottle having a vapor-deposited film by a plasma CVD method and to a method of forming the film.

### <Background Art>

In order to improve properties of various substrates, attempts have heretofore been made to vapor-deposit a film on the surfaces thereof by the plasma CVD method. In the field of packaging materials, for example, it is a known practice to improve gas-barrier properties by vapor-depositing a film on a plastic substrate such as of a container by the plasma CVD method.

For example, there has been known a method of producing a plastic container by varying the concentration of an organosilicon compound at the time of forming a silicon oxide as well as a barrier layer (vapor-deposited film) containing at least one kind of compound comprising at least one or two or more of carbon, hydrogen, silicon and oxygen on at least the one side of the plastic container by the plasma CVD method by using at least an organosilicon compound and oxygen or a gas having an oxidizing power (see patent document 1).
Patent document 1: JP-A-2000-255579

### Disclosure of the Invention

The vapor-deposited film by the method of the patent document 1 has an excellent barrier effect against various gases such as oxygen and the like but also has a problem of generating odor. This tendency becomes conspicuous particularly when the vapor-deposited film is formed on the surface of a biodegradable plastic such as a polylactic acid. If the above vapor-deposited film is to be formed on the inner surface of the plastic container, therefore, it is probable that the content in the container loses flavor. Therefore, improvements have been desired.

It is, therefore, an object of the present invention to provide a plastic formed article having a vapor-deposited film by the plasma CVD method not only featuring favorable gas-barrier property but also effectively preventing the generation of odor, and a method of forming a film.

According to the present invention, there is provided a plastic formed article comprising a plastic substrate and a vapor-deposited film on a surface of the plastic substrate by a plasma CVD method, wherein:
the vapor-deposited film includes a first vapor-deposited layer on the surface of the plastic substrate and a second vapor-deposited layer on the first vapor-deposited layer; and
the first vapor-deposited layer is a vapor-deposited organometal layer which does not contain oxygen as a constituent element.

In the plastic formed article of the present invention, it is desired that:
(1) The second vapor-deposited layer is a vapor-deposited oxide layer;
(2) The vapor-deposited organometal layer comprises an organosilicon polymer;
(3) The plastic substrate comprises a biodegradable resin and, particularly, a polylactic acid; and
(4) The plastic formed article is a container.

The invention further provides a method of forming a vapor-deposited film on a surface of a plastic substrate by a plasma CVD by feeding a reaction gas onto the plastic substrate, including steps of:
forming a first vapor-deposited layer on the surface of the plastic substrate by the plasma CVD by using, as a reaction gas, a gas of an organometal compound without containing oxygen in the molecules thereof; and
forming a second vapor-deposited layer on the first vapor-deposited layer by the plasma CVD by using a different reaction gas.

In the method of forming a vapor-deposited film of the invention, it is desired that:
(1) In the step of forming the second vapor-deposited layer, a mixed gas of a gas of the organometal compound and an oxidizing gas is used as the reaction gas;
(2) An organosilicon compound is used as the organometal compound;
(3) At least one compound selected from the group consisting of hexamethyldisilane, vinyltrimethylsilane, methylsilane, dimethylsilane, trimethylsilane, diethylsilane, propylsilane, phenylsilane and silazane is used as the organosilicon compound;
(4) In the step of forming the second vapor-deposited layer, a mixed gas of a gas of an organometal compound containing oxygen in the molecules thereof and an oxidizing gas is used as the reaction gas;
(5) Siloxane is used as the organometal compound containing oxygen in the molecules thereof;
(6) A polylactic acid substrate is used as the plastic substrate;
(7) A plastic container is used as the plastic substrate; and
(8) The plastic container is a bottle.

In the plastic formed article of the present invention, the vapor-deposited film on the surface of the plastic substrate by the plasma CVD method comprises a first vapor-deposited layer on the surface of the substrate and a second vapor-deposited layer on the first vapor-deposited layer. Here, what is particularly important is that the first vapor-deposited layer is a vapor-deposited organometal layer without containing oxygen or, in other words, the first vapor-deposited layer is formed by the plasma CVD method by using a gas of an organometal compound without oxygen atom as a reaction gas but without using the oxygen gas as the reaction gas. With the plastic formed article of the present invention having the vapor-deposited film of the above structure, no oxygen is present at the time of vapor-depositing the organometal layer (first vapor-deposited layer) that is closely adhered onto the surface of the plastic substrate making it possible to effectively avoid the surface of the plastic substrate from being decomposed or oxidized with oxygen.
Further, upon vapor-depositing the above organometal layer as the first vapor-deposited layer, the vapor-deposited organometal layer works as a protection film even at the time of vapor-depositing an oxide layer as the second vapor-deposited layer by using a reaction gas containing, for example, oxygen, and the plastic substrate is effectively avoided from being decomposed or oxidized with oxygen in forming the film. Therefore, the plastic formed article of the present invention is effectively suppressed from generating offensive odor or losing properties at the time of forming the film. When used, for example, as a packaging container, the plastic formed article of the present invention effectively prevents the flavor of the content in the container from being deteriorated by the generation of offensive odor. By vapor-depositing the oxide layer as the second vapor-deposited layer, further, excellent gas-barrier property can be secured.

It has also been known to vapor-deposit an inorganic film such as of diamond-like carbon (DLC) on the surface of a plastic substrate. When such an inorganic film is formed, generation of offensive odor is not recognized. Unlike the silicon oxide film, however, the inorganic film poses a problem of coloring and its use is limited in a field of packaging materials where, for example, transparency is required. In the plastic formed article of the present invention, on the other hand, the metal-deposited organometal layer which is the first vapor-deposited layer poses no problem of coloring. Therefore, the embodiment of vapor-depositing thereon an oxide layer as represented by the vapor-deposited silicon oxide layer as the second vapor-deposited layer can be effectively applied to the field of packaging materials, too, where transparency is required.

In the present invention, further, the vapor-deposited organometal layer provided as the first vapor-deposited layer features excellent flexibility since it contains no oxygen. Therefore, a highly close adhesion is maintained between the vapor-deposited film and the surface of the plastic substrate, effectively avoiding the peeling or occurrence of cracks, permitting the second vapor-deposited layer formed on the vapor-deposited organometal layer to exhibit its properties to a sufficient degree and, further, exhibiting a high gas-barrier property maintaining stability when the oxide layer is vapor-deposited as the second vapor-deposited layer.

### Description of the Drawing

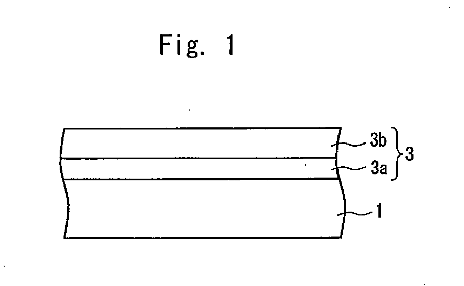

Fig. 1 is a sectional view illustrating a representative example of the structure of the vapor-deposited layers on a plastic formed article of the present invention.

### Best Mode for Carrying Out the Invention

Referring to Fig. 1, the plastic formed article of the invention comprises a plastic substrate 1 and a vapor-deposited film 3 formed on the surface thereof. Further, the vapor-deposited film 3 comprises a first vapor-deposited layer 3a formed on the surface of the plastic substrate 1 and a second vapor-deposited layer 3b formed thereon. In the example of Fig. 1, the film 3 is vapor-deposited on one surface only of the plastic substrate 1. However, the film 3 may be vapor-deposited on both surfaces of the plastic substrate 1, as a matter of course.

### (Plastic Substrate 1)

In the present invention, the plastic substrate 1 on which the film 3 is to be vapor-deposited is made from a widely known thermoplastic resin, such as a polyolefin, e.g., low-density polyethylene, high-density polyethylene, polypropylene, poly 1-butene, poly 4-methyl-1-pentene, and a random or a block copolymer of α-olefins such as ethylene, propylene, 1-butene or 4-methyl-1-pentene; a cyclic olefin copolymer; a vinyl resin, e.g., ethylene/vinyl acetate copolymer, ethylene/vinyl alcohol copolymer, ethylene/vinyl chloride copolymer, polyvinyl chloride, polyvinylidene chloride, vinyl chloride/vinylidene chloride copolymer, methyl polyacrylate or methyl polymethacrylate; a styrene resin, e.g., polystyrene, acrylonitrile/stylene copolymer, ABS or α-methylstyrene/styrene copolymer; a polyamide, e.g., nylon 6, nylon 6-6, nylon 6-10, nylon 11 or nylon 12; a polyester, e.g., polyethylene terephthalate, polybutylene terephthalate, polyethylene naphthalate, polyhydroxybutylate (PHB), random copolymer (PHBHV) of 3-hydroxybutylate and 3-hydroxyvalerate, random copolymer (PHBH) of 3-hydroxybutylate and 3-hydroxyhexanoate, poly(ε-caprolactone)(PCL), polyethylene succinate, polybutylene succinate (PBS), polybutylene succinate/adipate (PBAS), polyethylene terephthalate adipate (PETA) or polybutylene terephthalate adipate (PBTA); a polyphenylene oxide; a biodegradable resin, e.g., polylactic acid (PLA), polyglycolic acid (PGA), lactic acid/glycolic acid copolymer or acetic acid cellulose; or a blend thereof.

In the present invention, the greatest effect is exhibited when the plastic substrate 1 made from a biodegradable plastic such as polylactic acid is used. That is, when a vapor-deposited film is formed on the biodegradable plastic substrate, offensive odor generates most conspicuously. The present invention, however, makes it possible to reliably prevent the generation of offensive odor even when the biodegradable plastic is used.

There is no particular limitation on the form of the plastic substrate 1; i.e., the plastic substrate 1 may be in the form of a film or a sheet, or may be a container such as bottle, cup or tube, or may be any other formed article. There is, of course, no limitation on the forming means such as biaxial stretch-blow forming.

Further, the plastic substrate 1 may be a gas-barrier multi-layer structure forming the inner and outer layers by using the above-mentioned thermoplastic resin (preferably, olefin resin) and having an oxygen-absorbing layer between the inner layer and the outer layer.

### (Vapor-Deposited Film 3)

### - First Vapor-Deposited Layer 3a -

Concerning the vapor-deposited film 3 of the present invention, the first layer 3a vapor-deposited on the surface of the plastic substrate 1 is a vapor-deposited organometal layer without containing oxygen, and is formed by conducting a plasma CVD by using a gas of an organometal compound without containing oxygen atom as a reaction gas but without at all using the oxygen gas. That is, since the film is formed in a state where quite no oxygen is present or is generated, the plastic substrate 1 is reliably suppressed from being decomposed or oxidized with oxygen in the step of forming the film, reliably avoiding the generation of offensive odor or a loss of properties of the plastic substrate 1. Moreover, the vapor-deposited organometal layer 3a contains much carbon element together with the metal element and, as a result, is highly flexible and excellently adheres to the plastic substrate 1.

There is no particular limitation on the organometal compound used for vapor-depositing the organometal layer 3a provided it contains no oxygen and is capable of forming an organometal polymer film by the plasma reaction in the absence of oxygen. Its examples include organoaluminum compounds such as trialkylaluminum, organotitanium compounds such as tetraalkyltitanium, and various organosilicon compounds.
Among them, however, an organosilicon compound is particularly preferred from the standpoint of film formability.

Though not limited thereto only, examples of the organosilicon compound without containing oxygen atom include silane compounds such as hexamethyldisilane, vinyltrimethylsilane, methylsilane, dimethylsilane, trimethylsilane, ethyltrimethylsilane, trimethylvinylsilane, diethylsilane, propylsilane, phenylsilane and dimethylphenylsilane; and silazanes. The above organosilicon compounds can be used alone or in two or more kinds in combination.

In vapor-depositing the organometal layer 3a, no oxidizing gas such as oxygen is used as described earlier. For adjusting the concentration of the reaction gas, however, an inert gas such as argon gas or helium gas can be suitably used as a carrier gas together with the above organometal compound gas.

In the present invention, further, it is desired that the above vapor-deposited organometal layer 3a has a thickness which is not smaller than the surface roughness (Ra) of the plastic substrate 1 and, particularly, not smaller than the surface roughness (Ra) + 5 nm. If the thickness is smaller than the surface roughness (Ra) of the plastic substrate 1, the vapor-deposited organometal layer 3a fails to work as a protection film to a sufficient degree in the step of vapor-depositing the second layer 3b that will be described below. As a result, offensive odor generates and the plastic substrate 1 easily loses its properties. Generally, further, there is a limit on the surface roughness (Ra) of the plastic substrate 1, and the above conditions can be satisfied if the vapor-deposited organometal layer 3a has a thickness which is, usually, not smaller than 0. 1 nm and, particularly, not smaller than 0.5 nm. Even if the organometal layer 3a is too thickly vapor-deposited, no further increased effect is obtained but rather disadvantage results in cost. It is, therefore, desired that the vapor-deposited organometal layer 3a has a thickness that lies within the above range and is not larger than 50 nm.
Here, the surface roughness (Ra) of the plastic substrate 1 is an arithmetic mean roughness (10-point mean roughness) specified under the JIS B 0601-1994.

### - Second Vapor-Deposited Layer 3b -

In the present invention, the second layer 3b vapor-deposited on the above-mentioned vapor-deposited organometal layer 3a may be a layer having suitable properties that meet the use of the plastic formed article (substrate 1) and is, desirably, a vapor-deposited oxide layer for enhancing gas-barrier property or is a vapor-deposited hydrocarbon layer for enhancing waterproof property.

The vapor-deposited oxide layer is formed by the plasma CVD by using an oxidizing gas together with the organometal compound gas as the reaction gas.
The organometal compound used for vapor-depositing the oxide layer may be either the one that has an oxygen atom or the one that has no oxygen atom. As the organometal compound without the oxygen atom, there can be exemplified those used for vapor-depositing the organometal layer 3a. As the organometal compound having the oxygen atom, there can be exemplified organotitanium compounds such as alkoxytitanium; siloxane compounds such as organosilane compounds like methyltriethoxysilane, vinyltriethoxysilane, vinyltrimethoxysilane, tetramethoxysilane, tetraethoxysilane, phenyltrimethoxysilane, methyltrimethoxysilane and methyltriethoxysilane; and organosiloxane compounds, such as octamethylcyclotetrasiloxane, 1,1,3,3-tetramethyldisiloxane and hexamethyldisiloxane. The above organometal compounds can be used alone or in two or more kinds in combination.

In the step of vapor-depositing the oxide layer as the second vapor-deposited layer 3b in the present invention, it is allowable to use the reaction gas used in the step of vapor-depositing the organometal layer 3a. From the standpoint of simplifying the step of forming the film, however, it is desired to use the organometal compound without oxygen atom, that is used for vapor-depositing the organometal layer 3a.

As the oxidizing gas used for vapor-depositing the oxide layer, there can be used oxygen or NOx. In the step of vapor-depositing the oxide film, too, the above-mentioned inert gas can be suitably used as a carrier gas, as a matter of course.

In the present invention, the vapor-deposited layer of oxide has a composition which is ideally MOx (M: metal atom possessed by an organometal compound). The layer, however, may contain a carbon (C) component stemming from an organic group of the organometal compound. For example, the carbon (C) component may be much distributed in the region on the side of the vapor-deposited organometal layer 3a (first vapor-deposited layer) to enhance the adhesion to the vapor-deposited organometal layer 3a. Upon much distributing the carbon (C) component in the region on the surface side, further, the waterproof property can be enhanced. From the standpoint of maintaining excellent gas-barrier property, in general, it is desired that a region is formed maintaining a thickness of not smaller than 4 nm and containing carbon (C) at a concentration of not higher than 5 atomic % based on the three elements of metal (M), oxygen (O) and carbon (C). From the standpoint of enhancing the waterproof property and suppressing the metal (M) from eluting into water, further, it is desired that a region is formed maintaining a thickness of not smaller than 0.2 nm on the outer surface side (surface side opposite to the plastic substrate 1) and containing carbon (C) at a concentration of not smaller than 15 atomic % based on the above three elements.
The vapor-deposited oxide layer exhibits an increased gas-barrier property with an increase in the thickness thereof. Depending upon the use, therefore, the thickness is set so as to exhibit a desired gas-barrier property. In a field of containers, in general, and, particularly, plastic containers (especially bottles) made from a biodegradable resin such as polylactic acid, a high gas-barrier property is required.
Therefore, the thickness is set to be not less than 5 nm and, particularly, in a range of about 10 to about 50 nm.

Further, the vapor-deposited hydrocarbon layer has been known as the so-called DLC (diamond-like carbon) film. This layer is formed by the plasma CVD by using various kinds of hydrocarbon gases. There is no particular limitation on the hydrocarbons that can be used as the reaction gases. From the standpoint of easy gasification, however, it is desired to use unsaturated aliphatic hydrocarbons and aromatic hydrocarbons. As unsaturated aliphatic hydrocarbons, there can be concretely exemplified alkenes such as ethylene, propylene, butene and pentene; alkynes such as acetylene and methylacetylene; alkadienes such as butadiene and pentadiene; and cycloalkenes such as cyclopentene and cyclohexene. As the aromatic hydrocarbons, there can be exemplified benzene, toluene, xylene, indene, naphthalene and phenanthrene. Among them, the unsaturated aliphatic hydrocarbons are preferred and, particularly, ethylene and acetylene are most preferred.

The vapor-deposited hydrocarbon layer has a problem of developing color but has excellent waterproof property. In the use where the plastic formed articles do not require transparency but require waterproof property, therefore, the above vapor-deposited hydrocarbon layer is formed as the second vapor-deposited layer 3b having a suitable thickness on the first vapor-deposited layer 3a.

In the present invention, the second vapor-deposited layer 3b can be, further, formed from the above-mentioned vapor-deposited oxide layer and a vapor-deposited hydrocarbon layer. In this case, it is desired to form the vapor-deposited oxide layer on the first vapor-deposited layer 3a and to, further, form the vapor-deposited hydrocarbon layer thereon.
This not only makes it possible to attain excellent gas-barrier property and waterproof property but also to reliably prevent the elution of metal component from the vapor-deposited oxide layer.

### <Vapor Deposition>

In the present invention, the film 3 can be vapor-deposed by the plasma CVD according to a known method but using the above-mentioned reaction gas. For example, the above first vapor-deposited layer 3a and the second vapor-deposited layer 3b can be formed by the plasma CVD based on a glow discharge by using, for example, microwaves or radio-frequency waves.

Concretely, the plastic substrate 1 on which the film is to be formed is arranged in a chamber maintained at a predetermined degree of vacuum, and the film is formed thereon by feeding a predetermined reaction gas onto the film-forming side of the substrate 1 and feeding microwaves of a predetermined output. In the case of radio-frequency waves, the substrate is held between a pair of electrodes, and the film is formed thereon by feeding the reaction gas and applying the radio-frequency waves of a predetermined output in the same manner as above.

At first, therefore, a gas of an organometal compound without containing oxygen is used as the reaction gas, and the first layer (organometal layer) 3a is vapor-deposited by the plasma CVD while feeding the reaction gas and, as required, a carrier gas. Next, the second layer 3b (oxide layer or hydrocarbon layer) is vapor-deposited by the plasma CVD while feeding he above reaction gas and, as required, the carrier gas.

When the oxide layer is to be vapor-deposited as the second vapor-deposited layer 3b, there are used the oxidizing gas such as oxygen or the like as well as the gas of an organometal compound without containing oxygen (e.g., gas of the organometal compound used in the step of vapor-depositing the first layer 3a) or the gas of an organometal compound containing oxygen in the molecules thereof as the reaction gas as described earlier.

In vapor-depositing the oxide layer, further, the carbon concentration in the film can be decreased by increasing the output of glow discharge and, further, the oxygen concentration in the film can be increased by increasing the concentration of the oxidizing gas such as of oxygen or the like. By utilizing this, therefore, the carbon concentration and the oxygen concentration in the film can be adjusted, or the gradients of concentrations can be formed in the direction of thickness.
In the case of the vapor-deposited hydrocarbon layer, further, the film can be formed by the glow discharge of a relatively low output as compared to that of vapor-depositing the oxide layer.

The thicknesses of the above first vapor-deposited layer 3a and the second vapor-deposited layer 3b can be, further, adjusted relying upon the film-forming time.

The thus formed plastic formed article of the present invention has the vapor-deposited organometal layer as the first vapor-deposited layer 3a preventing the generation of offensive odor at the time of forming the film or preventing the properties of the plastic substrate 1 from being deteriorated by the formation of film. When the present invention is applied to a plastic container, in particular, a loss of flavor of the content in the container is effectively avoided. With the oxide layer being vapor-deposited as the second vapor-deposited layer 3b, further, the plastic formed article exhibits excellent barrier property against gases such as oxygen and the like, and can, therefore, be particularly favorably applied to a plastic container such as bottle. Most desirably, the film 3 is vapor-deposited on the inner surface of the container.

### EXAMPLES

The invention will now be described by way of Examples to which only, however, the invention is in no way limited.

### (Method of Experiments)

A container (surface roughness on the inner surface of the container: Ra = 5 nm, amount of oxygen permeation: 0.5 cc/bottle/day) formed by using a polylactic acid (PLA) which is a biodegradable resin was set in a chamber. Thereafter, the interior and the exterior of the container were evacuated, a reaction gas necessary for the vapor deposition was introduced and, after a predetermined pressure was attained, microwaves of 2.45 GHz were introduced to effect the vapor deposition by plasma. Through the step of vapor deposition, there were continuously vapor-deposited a first layer comprising an organosilicon polymer film and a second layer comprising a silicon oxide film or a hydrocarbon film.
The surface roughness Ra of the container was measured by using a surface roughness meter AFM (Nano Scope III, manufactured by Digital Instruments Co.) in compliance with the JIS B0601-1994, and was expressed as an arithmetic mean roughness.

In the following Examples 1 to 4 and in Comparative Example, the second layer was vapor-deposited by using a mixed gas of a hexamethyldisiloxane (HMDSO) and oxygen (volume mixing ratio of 1:10) as the reaction gas, and the first layer was vapor-deposited while varying the reaction gas.

The vapor-deposited film was evaluated for its flavor-retaining property by a method described below and was measured for its thickness by a method described below.

### (Flavor-Retaining Property)

The bottles on which the film has been vapor-deposited were filled with water and, after preserved at 37°C for 4 weeks, were evaluated by the panelists based on a 4-point flavor evaluation method. The results were evaluated on the following basis.
1: Water in the bottle was tasteless.
2 : Water in the bottle slightly tasted (could be perceived if carefully tasted).
3: Water in the bottle tasted (could be perceived as soon as the one put the water into the mouth).
4: Water in the bottle tasted considerably (tasted distinctly).

### (Barrier Property)

The amount of oxygen permeation was measured by using an oxygen barrier tester, OX-TRAN (37°C) manufactured by MOCON Co., and the barrier property was evaluated based on the amount of permeation.

### (Thickness of the Vapor-Deposited Film)

The vapor-deposited films were measured for their thicknesses by using an X-ray diffraction device (X' Pert Pro MRD) manufactured by Phillips Co. in compliance with the X-ray reflection factor method.

### (Example 1)

A trimethylvinylsilane (TMVS) was provided as the organometal compound without oxygen atom. By using the TMVS only as the reaction gas, the microwaves were oscillated with an output of 500 W for 2 seconds to vapor-deposit an organometal layer that was the first vapor-deposited layer. Next, by using a mixed gas of a hexamethyldisiloxane (HMDSO) and oxygen, the microwaves were oscillated with an output of 500 W for 8 seconds to vapor-deposit an oxide layer that was the second vapor-deposited layer.
In the thus vapor-deposited film, the vapor-deposited organometal layer possessed a thickness of 8 nm and the vapor-deposited oxide layer possessed a thickness of 20 nm. No offensive odor was generated at the time of vapor deposition, and flavor-retaining property was favorable. Oxygen-barrier property was as favorable as 0.03 cc/bottle/day. These results are shown in Table 1.

### (Example 2)

An ethyltrimethylsilane (ETMS) was provided as the organometal compound without oxygen atom. By using the ETMS only as the reaction gas, an organometal layer was vapor-deposited as the first vapor-deposited layer in the same manner as in Example 1. Next, an oxide layer was vapor-deposited as the second vapor-deposited layer in quite the same manner as in Example 1.
In the thus vapor-deposited film, the vapor-deposited organometal layer possessed a thickness of 8 nm and the vapor-deposited oxide layer possessed a thickness of 20 nm. No offensive odor was generated at the time of vapor deposition, and flavor-retaining property was favorable. Oxygen-barrier property was as favorable as 0.03 cc/bottle/day. These results are shown in Table 1.

### (Comparative Example 1)

A hexamethyldisiloxane (HMDSO) was provided as the organometal compound without oxygen atom. By using the HMDSO only as the reaction gas, an organometal layer was vapor-deposited as the first vapor-deposited layer in the same manner as in Example 1. Next, an oxide layer was vapor-deposited as the second vapor-deposited layer in quite the same manner as in Example 1.
In the thus vapor-deposited film, the vapor-deposited organometal layer possessed a thickness of 8 nm and the vapor-deposited oxide layer possessed a thickness of 20 nm. Offensive odor was generated at the time of vapor deposition, and flavor-retaining property was impaired. Oxygen-barrier property was as favorable as 0.03 cc/bottle/day. These results are shown in Table 1.

### (Example 3)

A container (surface roughness on the inner surface of the container: Ra = 1 nm, amount of oxygen permeation: 0.05 cc/bottle/day) formed by using a polyethylene terephthalate (PET) was provided.
By using the above PET bottle and by using the TMVS only as the reaction gas, the second layer (oxide layer) was vapor-deposited in quite the same manner as in Example 1 but vapor-depositing the first layer (organometal layer) by oscillating the microwaves with an output of 500 W for 1 second.
In the thus vapor-deposited film, the vapor-deposited organometal layer possessed a thickness of 3 nm and the vapor-deposited oxide layer possessed a thickness of 20 nm. No offensive odor was generated at the time of vapor deposition, and flavor-retaining property was favorable. Oxygen-barrier property was as favorable as 0.002 cc/bottle/day. These results are shown in Table 1.

### (Example 4)

By using the TMVS only as the reaction gas, a first layer (organometal layer) and a second layer (oxide layer; thickness of 20 nm) were vapor-deposited on the inner surface of a container (inner surface roughness, Ra = 5 nm) of polylactic acid in the same manner as in Example 1 but by oscillating the microwaves with an output of 500 W for 1 second to vapor-deposit the first layer (organometal layer) maintaining a thickness of 3 nm. As a result, offensive odor was slightly generated at the time of vapor deposition, which, however, was not as strong as in Comparative Example 1. Further, the flavor-retaining property was slightly inferior to that of Example 1 but was better than that of Comparative Example 1.

### (Example 5)

An organometal layer was vapor-deposited as the first vapor-deposited layer in the same manner as in Example 1. Next, a hydrocarbon layer (thickness of 30 nm) was vapor-deposited as the second vapor-deposited layer by using an acetylene gas as the reaction gas. In the thus vapor-deposited film, the vapor-deposited organometal layer possessed a thickness of 8 nm and the vapor-deposited oxide layer possessed a thickness of 20 nm. No offensive odor was generated at the time of vapor deposition, and flavor-retaining property was favorable.
Oxygen-barrier property was as favorable as 0.03 cc/bottle/day. These results are shown in Table 1.

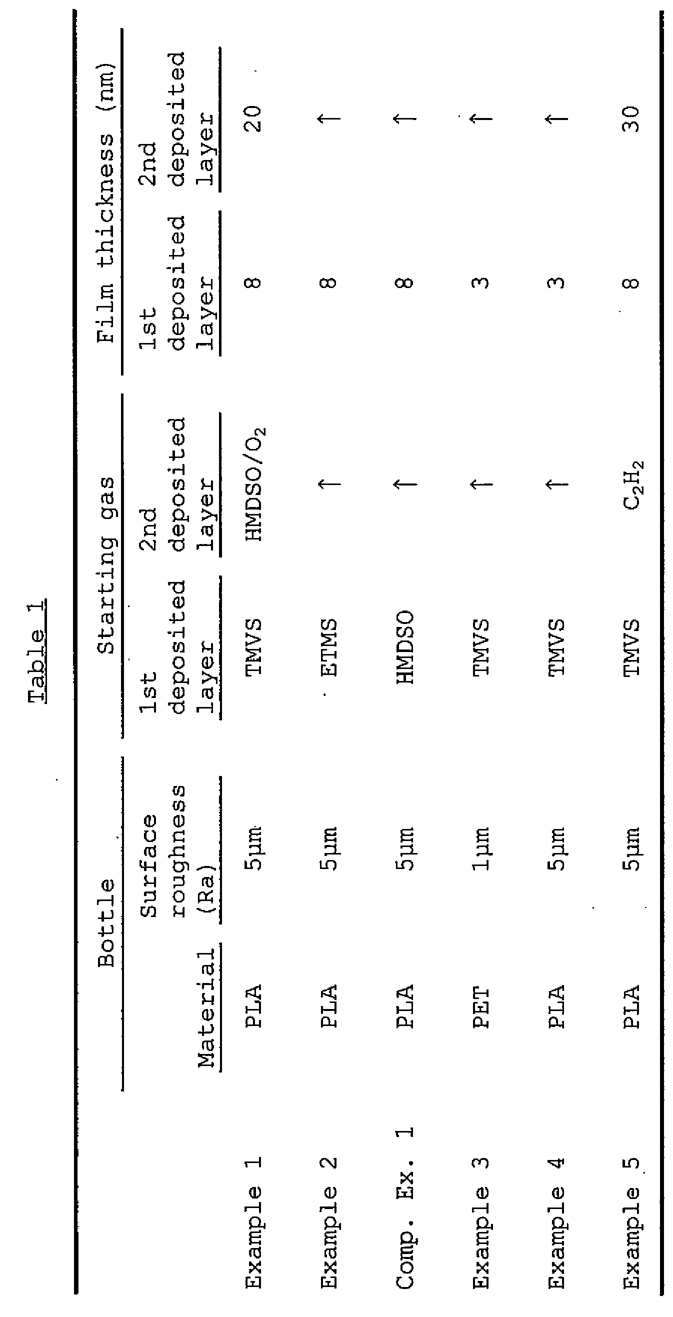

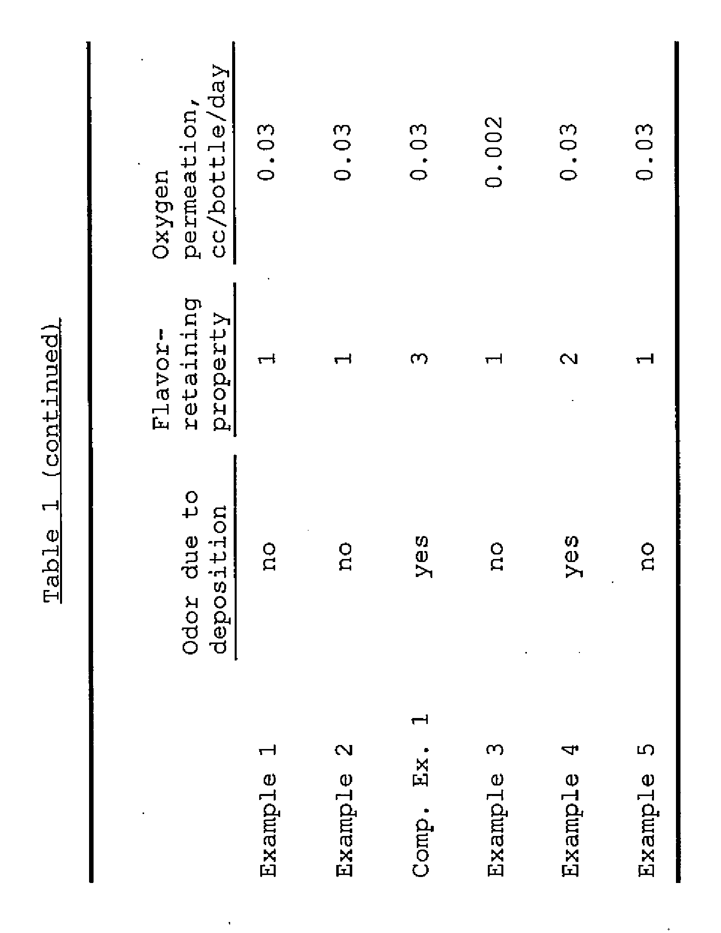

## Claims

1. A plastic formed article comprising a plastic substrate and a vapor-deposited film on a surface of said plastic substrate by a plasma CVD method, wherein:
said vapor-deposited film includes a first vapor-deposited layer on the surface of said plastic substrate and a second vapor-deposited layer on said first vapor-deposited layer; and
said first vapor-deposited layer is a vapor-deposited organometal layer which does not contain oxygen as a constituent element.

2. The plastic formed article according to claim 1, wherein said second vapor-deposited layer is a vapor-deposited oxide layer.

3. The plastic formed article according to claim 1, wherein said vapor-deposited organometal layer comprises an organosilicon polymer.

4. The plastic formed article according to claim 1, wherein said plastic substrate comprises a biodegradable resin.

5. The plastic formed article according to claim 1, wherein said plastic formed article is a container.

6. A method of forming a vapor-deposited film on a surface of a plastic substrate by a plasma CVD by feeding a reaction gas onto the plastic substrate, including steps of:
forming a first vapor-deposited layer on the surface of the plastic substrate by the plasma CVD by using, as a reaction gas, a gas of an organometal compound without containing oxygen in the molecules thereof; and
forming a second vapor-deposited layer on the first vapor-deposited layer by the plasma CVD by using a different reaction gas.

7. The method of forming a vapor-deposited film according to claim 6, wherein in the step of forming the second vapor-deposited layer, a mixed gas of a gas of the organometal compound and an oxidizing gas is used as the reaction gas.

8. The method of forming a vapor-deposited film according to claim 6, wherein an organosilicon compound is used as said organometal compound.

9. The method of forming a vapor-deposited film according to claim 8, wherein at least one compound selected from the group consisting of hexamethyldisilane, vinyltrimethylsilane, methylsilane, dimethylsilane, trimethylsilane, diethylsilane, propylsilane, phenylsilane and silazane is used as said organosilicon compound.

10. The method of forming a vapor-deposited film according to claim 6, wherein in the step of the second vapor-deposited layer, a mixed gas of a gas of an organometal compound containing oxygen in the molecules thereof and an oxidizing gas is used as the reaction gas.

11. The method of forming a vapor-deposited film according to claim 10, wherein a siloxane is used as the organometal compound containing oxygen in the molecules thereof.

12. The method of forming a vapor-deposited film according to claim 6, wherein a biodegradable resin substrate is used as said plastic substrate.

13. The method of forming a vapor-deposited film according to claim 6, wherein a plastic container is used as said plastic substrate.

14. The method of forming a vapor-deposited film according to claim 13, wherein the plastic container is a bottle.
